# EUROPEAN PATENT APPLICATION

(11) **EP 4 572 554 A1**
(43) Date of publication of application: **18.06.2025**
(21) Application number: 24213402.1
(22) Date of filing: 15.11.2024
(51) Int. Cl.: H10B 10/00, H10D 89/10, H10D 30/67, H10D 86/01, H10D 86/00, H10D 88/00

(54) **SRAM CELL WITH THIN FILM TRANSISTOR (TFT) ARRANGEMENT IN THE INTERCONNECT REGION**

(30) Priority: 15.12.2023 US 202318541087
(71) Applicant: Intel Corporation, Santa Clara, CA 95054 (US)
(72) Inventor: FROST, Denzil, Rio Rancho, 87124 (US)
(74) Representative: 2SPL Patentanwälte PartG mbB

(57) **Abstract**

Techniques are provided for making an SRAM cell using TFTs within the interconnect region of an integrated circuit. The TFTs may be arranged in patterned strips that include a semiconductor layer and contacts formed either above or below the semiconductor layer to provide the source or drain terminals of the transistors. One or more gate contacts are also formed on a dielectric layer between the one or more gate contacts and the semiconductor layer. The semiconductor layers of the various TFTs in a given SRAM cell may be arranged at least partially in a same interconnect layer and parallel to one another in a staggered arrangement to allow for easier routing of various interconnects between the different TFTs. The SRAM cells can be arranged in a two-dimensional array and stacked in a vertical direction such that multiple tiers of SRAM cell arrays can be formed in the interconnect region.

## Description

### BACKGROUND

As integrated circuits continue to scale downward in size, a number of challenges arise. For instance, as transistor area decreases, so too do the dimensions for interconnects made to the various transistor structures, such as gate structures, drain regions, and source regions. This can be challenging for certain circuit arrangements that need to fit within a given small footprint on the chip. Accordingly, there remain a number of non-trivial challenges with respect to the formation of integrated circuits.

### BRIEF DESCRIPTION OF THE DRAWINGS

Figure 1A is a cross-sectional view that illustrates an example portion of an integrated circuit configured with an interconnect region having tiers of thin film transistors (TFTs), in accordance with an embodiment of the present disclosure.
Figures 2A is a circuit schematic of an example static random-access memory (SRAM) cell.
Figure 2B is a plan view schematic of TFTs arranged within interconnects to form an SRAM cell, in accordance with an embodiment of the present disclosure.
Figures 3A - 3D illustrate cross-section views of each of the TFTs from Figure 2B, in accordance with some embodiments of the present disclosure.
Figures 4A - 4E illustrate cross-section views of a fabrication process to form one of the TFTs from Figure 2B, in accordance with an embodiment of the present disclosure.
Figure 5 illustrates a cross-section view of a chip package containing one or more semiconductor dies, in accordance with some embodiments of the present disclosure.
Figure 6 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein for making an SRAM cell using thin film transistors (TFTs) within the interconnect region of an integrated circuit. In an example, the SRAM cell is configured as a 6T cell, and includes four n-type transistors and two p-type transistors, although the techniques can be used in any number of applications in which transistors of a memory cell can be implemented using a TFT architecture within the interconnect region above a device layer. According to some embodiments, TFTs may be arranged in patterned strips that include a semiconductor layer and contacts formed either above or below the semiconductor layer to provide the source or drain terminals of the transistor. One or more gate contacts are also formed on a dielectric layer between the one or more gate contacts and the semiconductor layer. The semiconductor layers of the various TFTs in a given SRAM cell may be arranged in a substantially coplanar fashion on a same interconnect layer and parallel to one another in a staggered arrangement to allow for easier routing of various interconnects between the different TFTs. In some cases, two or more TFTs can share the same semiconductor layer to increase device density in a given footprint. According to some embodiments, the SRAM cells are arranged in a two-dimensional array within one or more interconnect layers and stacked in a vertical direction such that multiple tiers of SRAM cell arrays can be formed within the interconnect region. Numerous variations and embodiments will be apparent in light of this disclosure.

### General Overview

As previously noted above, there are a number of non-trivial challenges with respect to forming certain circuits. For example, an SRAM cell memory cell is used for many applications, but its design can be cumbersome as it requires connecting a number (e.g., six) of transistors together (e.g., a 6T cell configuration may include four n-type transistors and two p-type transistors). This can make area scaling difficult with multiple SRAM cells on a semiconductor substrate.

Thus, techniques are provided herein to form one or more SRAM cells using thin film transistors (TFTs) in the interconnect region above a device layer of an integrated circuit. The TFTs can be used, for example, in a backend memory structure that may be one memory structure of an array of similar memory structures (e.g., SRAM cells) formed within various levels of interconnect layers over semiconductor devices (e.g., transistors) of a previously-formed device layer. According to some embodiments, a given TFT structure includes a semiconductor or channel region, a gate electrode, a gate dielectric between the gate electrode and the semiconductor region, and one or more contacts to the top or bottom surfaces of the semiconductor region that act as source or drain regions for the transistor. An SRAM cell may include a number of such TFT structures and be implemented with multiple distinct semiconductor regions or layers of differing lengths arranged in a staggered fashion, with some of the TFT structures possibly sharing a semiconductor layer, according to some example embodiments.

According to some embodiments, the six TFTs of a 6T SRAM cell (e.g., including four n-type and two p-type transistors) may be provided across four semiconductor layers arranged substantially coplanar with each other on the same interconnect layer. Two of the four semiconductor layers may be longer n-type layers while the other two of the four semiconductor layers are shorter p-type layers. Accordingly, a first set of n-type transistors may share one longer n-type semiconductor layer while a second set of n-type transistors share the other longer n-type semiconductor layer. Each shorter p-type semiconductor layer may be used to provide a single p-type TFT, according to some embodiments. The four semiconductor layers may be arranged substantially parallel to one another and in a diagonally staggered or offset formation to provide space to route signals between the various transistor elements of the SRAM cell. This arrangement can be used to form the SRAM cell in a relatively small footprint, allowing for dense arrays of similar SRAM cells across a given interconnect layer and across multiple levels of interconnect layers (e.g., 3D array).

According to an embodiment, an integrated circuit includes a plurality of semiconductor devices, an interconnect region above the plurality of semiconductor devices and having a plurality of interconnect layers, and a plurality of thin film transistors (TFTs) arranged coplanar with one another on an interconnect layer of the plurality of interconnect layers. The plurality of TFTs include a static random-access memory (SRAM) cell having four n-type TFTs and two p-type TFTs. Other examples may have fewer TFTs, such as a 5T or 4T configuration, where two or more distinct semiconductor layers are arranged in a staggered parallel fashion.

According to another embodiment, a chip package includes one or more dies. At least one of the one or more dies includes an interconnect region above a plurality of semiconductor devices and having a plurality of interconnect layers, and a plurality of thin film transistors (TFTs) arranged coplanar with one another on an interconnect layer of the plurality of interconnect layers. The plurality of TFTs include a static random-access memory (SRAM) cell having four n-type TFTs and two p-type TFTs. Other examples may have fewer TFTs, where two or more distinct semiconductor layers are arranged in a staggered parallel fashion.

According to another embodiment, an integrated circuit includes an interconnect region above a plurality of semiconductor devices and having a plurality of interconnect layers, a first n-type TFT and a second n-type TFT sharing a first semiconductor layer, a first p-type TFT having a second semiconductor layer, a second p-type TFT having a third semiconductor layer, and a third n-type TFT and a fourth n-type TFT sharing a fourth semiconductor layer. Each of the TFTs are on a same interconnect layer of the plurality of interconnect layers. Each of the first semiconductor layer, second semiconductor layer, third semiconductor layer, and fourth semiconductor layer are arranged such that their longest sides are parallel to one another.

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX or EDS); secondary ion mass spectrometry (SIMS); time-of-flight SIMS (ToF-SIMS); atomic probe imaging or tomography (APT); local electrode atom probe (LEAP) techniques; 3D tomography; or high resolution physical or chemical analysis, to name a few suitable example analytical tools. For instance, in some example embodiments, such tools may indicate the presence of various TFTs in an interconnect layer that are arranged as an SRAM cell. The cell may include, for instance, two or more distinct semiconductor layers arranged in a staggered parallel fashion.

It should be readily understood that the meaning of "above" and "over" in the present disclosure should be interpreted in the broadest manner such that "above" and "over" not only mean "directly on" something but also include the meaning of over something with an intermediate feature or a layer therebetween. The meaning of "on" or "directly on" in the present disclosure should be interpreted to mean something that is on something else with no intermediate feature or layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The integrated circuit or structure may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer. Example layers include, for instance, a liner or barrier layer (e.g., a relatively thin layer of tantalum nitride), an etch stop layer (e.g., a relatively thin layer of silicon nitride), an interconnect layer (e.g., a relatively thick layer that includes dielectric material and one or more conductive interconnect features and/or active devices and/or passive devices), and a device layer (e.g., a relatively thick layer that includes metal oxide semiconductor field effect transistors or MOSFETs along with dielectric materials and conductive materials)

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the materials has an element that is not in the other material.

### Architecture

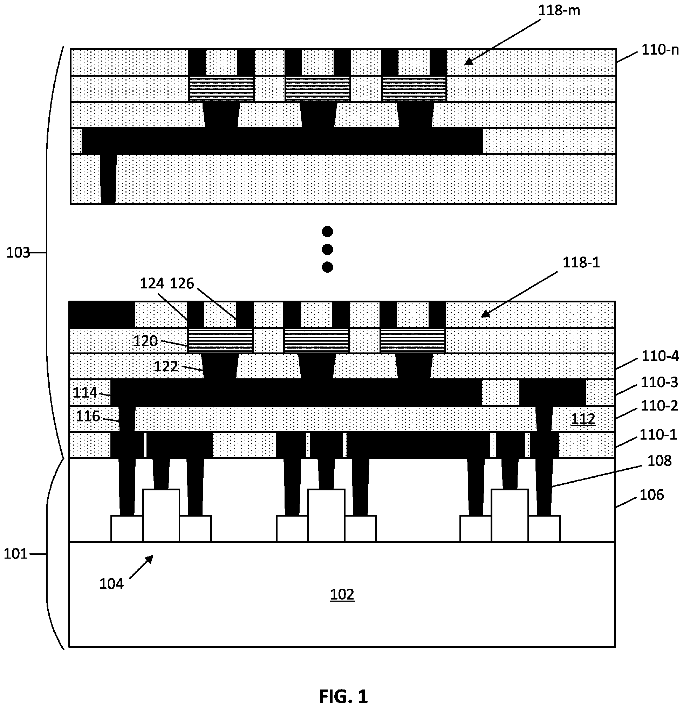

Figure 1 is a cross-sectional view that illustrates an example portion of an integrated circuit having an interconnect region 103 above a device region 101 that includes a plurality of semiconductor devices 104, in accordance with an embodiment of the present disclosure. The semiconductor devices 104 in this example are non-planar metal oxide semiconductor (MOS) transistors, such as tri-gate, forksheet, or gate-all-around (GAA) transistors, although other transistor topologies and types can also benefit from the techniques provided herein, as will be appreciated (e.g., planar transistors, thin film transistors, or any other transistors to which contact can be made). The semiconductor devices 104 may be configured for any number of functions, such as logic or compute transistors, input/output (I/O) transistors, access or switching transistors, and/or radio frequency (RF) transistors, to name a few examples.

According to some embodiments, in addition to semiconductor devices 104, device region 101 may include, for example, one or more other layers or structures associated with the semiconductor devices 104. For example, device region 101 can also include a substrate 102 and one or more dielectric layers 106 that surround active and/or conductive portions of the semiconductor devices 104. Device region 101 may also include one or more conductive contacts 108 that provide electrical contact to transistor elements such as gate structures, drain regions, or source regions. Conductive contacts 108 may include, for example, tungsten, ruthenium, molybdenum, or cobalt, although other metal or metal alloy materials may be used as well. Some embodiments may include a local interconnect (e.g., via or line) that connects a given contact 108 to an interconnect feature within the interconnect region 103.

Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material from and/or upon which transistors can be formed. Alternatively, the substrate can be a semiconductor-on-insulator substrate having a desired semiconductor layer over a buried insulator layer (e.g., silicon over silicon dioxide). Alternatively, the substrate can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, backside processing is used to remove substrate 102 and form additional backside interconnect layers. The techniques provided herein may be used to provide multi-tier memory structures within frontside and/or backside interconnect structures, as will be appreciated.

Interconnect region 103 includes any number (n) of interconnect layers 110-1 to 110-n stacked over one another. Each interconnect layer can include a dielectric material 112 along with one or more different conductive interconnect features (e.g., vias and lines), active devices (e.g., transistors, diodes), and/or passive devices (e.g., capacitors, resistors, inductors). Dielectric material 112 can be any dielectric, such as silicon oxide, silicon oxycarbide, silicon nitride, or silicon oxynitride. Dielectric material 112 may be formed using any known dielectric deposition technique such as chemical vapor deposition (CVD), plasma-enhanced chemical vapor deposition (PECVD), flowable CVD, spin-on dielectric, or atomic layer deposition (ALD). The one or more conductive interconnect features can include any number of conductive traces 114 and conductive vias 116 arranged in any pattern across the interconnect layers 110-1 to 110-n to carry signal and/or power voltages to/from the various semiconductor devices 104. As used herein, conducive vias, such as conductive via 116, extend at least partially through an interconnect layer to connect between conductive traces on an upper interconnect layer and/or a lower interconnect layer, while conductive contacts, such as conductive contact 108, extend at least partially through a portion of dielectric layer 106 or any interconnect layer to contact one or more transistor elements. Interconnect layers are sometimes called metallization layers (e.g., such as M0 through M15). In some embodiments, a given metallization layer may include two adjacent interconnect layers with vias in one of the layers and metal traces in the other of the two layers.

Any of conductive traces 114 and conductive vias 116 can include any number of conductive materials, with some examples including copper, ruthenium, tungsten, cobalt, molybdenum, titanium, tantalum, and alloys thereof. In some example cases, any of conductive traces 114 and conductive vias 116 include a relatively thin liner or barrier, such as manganese, ruthenium, titanium nitride, titanium silicide, tungsten carbo-nitride (WCN), physical vapor deposited (PVD) or ALD tungsten, tantalum, or tantalum nitride, to name a few examples.

Note that each of the various conductive vias 116 and conductive contacts 108 are shown with tapered profiles to indicate a more natural appearance due to the etching process used to form the openings, although such tapering may not always be present. Any degree of tapering may be observed depending on the etch parameters used and the thickness of the dielectric layer being etched through. Furthermore, conductive vias may be stacked one over the other through different dielectric layers of interconnect region 103. However, in some examples, a single via recess may be formed through more than one dielectric layer yielding a taller, more tapered conductive via that extends through two or more dielectric layers (e.g., a deep via or supervia).

As can be further seen in this example embodiment, interconnect region 103 also includes tiers of memory arrays 118-1 - 118m, with each of the m memory arrays having any number of backend memory circuits, such as SRAM cells. Each of the memory arrays may extend vertically across any number of interconnect layers (e.g., one, two or many). In some embodiments, a given memory array 118-1 includes a plurality of TFT structures 120 arranged to provide any number of SRAM cells. According to some embodiments, a conductive via 122 extends between certain TFT structures 120 and conductive trace 114 to make backside connection to the TFT structures 120. In some other embodiments, the TFT structures 120 along the same row sit directly on conductive trace 114.

Additional conductive traces 124/126 may each couple to a corresponding region of a given TFT structure 120. Additional conductive traces 124/126 may provide interconnection between various other TFT structures 120 to form an SRAM cell, according to some embodiments. Conductive trace 114 may be, for example, a bitline of several parallel bitlines that extend beneath any number of TFT structures 120. Additional conductive traces 124/126 may represent, for example, wordlines or other local interconnect lines connecting to the contacts of any number of TFT structures 120. TFT structures 120 can include any number of layers to form a transistor with source or drain regions coupled to conductive trace 114 and either additional conductive trace 124/126. This example shows TFT structure 120 contained within a single interconnect layer, but other embodiments may have TFT structures that extend vertically through two or more such interconnect layers. Further note that, in some embodiments, there is a relatively thin etch stop layer between adjacent interconnect layers, such as between any adjacent interconnect layers 110. Such etch stops may have a thickness in the range of, for example, 2 nm to 10 nm, and may include, for instance, silicon nitride, silicon oxynitride, or silicon oxycarbonitride, to name few examples.

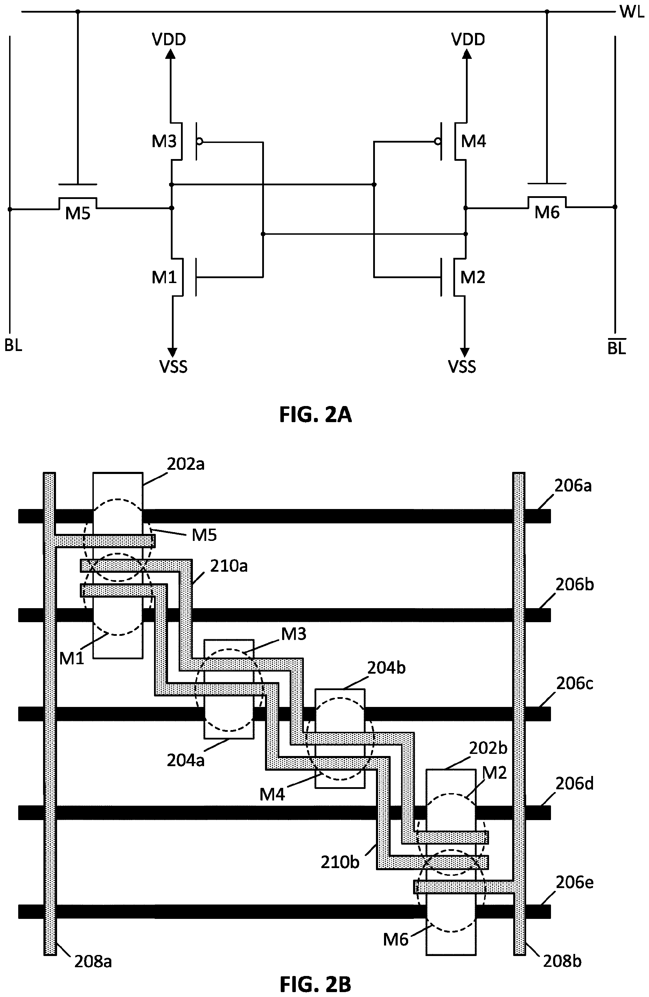

Figure 2A is a circuit schematic of an example SRAM cell and Figure 2B illustrates a plan view of TFT structures in an SRAM arrangement, according to some embodiments. As can be seen in this example, the SRAM cell includes six transistors (M1 - M6) to provide a 6T SRAM cell, with four memory transistors arranged as flip-flops broken into two n-type transistors (M1 and M2) and two p-type transistors (M3 and M4), and two n-type access transistors (M5 and M6). In the flip-flop arrangement, the gates of M1 and M3 are coupled together and are also coupled to a common source/drain terminal between M2 and M4. Similarly, the gates of M2 and M4 are coupled together and are also coupled to a common source/drain terminal between M1 and M3. Access transistor M5 is coupled between the common source/drain terminal between M1 and M3 and a first bitline BL while access transistor M6 is coupled between the common source/drain terminal between M1 and M3 and a second bitline B̅L̅. The gates of each access transistor M5 and M6 are coupled to a wordline WL. The criss-crossing interconnects between the memory transistors can be complicated to arrange using traditional interconnect methods. Other SRAM cells may be configured with fewer transistors, or more, and the techniques provided herein may benefit any such cell configurations.

According to some embodiments, TFTs may be arranged along a given interconnect layer in a staggered formation as illustrated in the plan view of Figure 2B to provide an SRAM cell in a relatively small footprint. The SRAM cell includes the six transistors M1 - M6 across four semiconductor regions, according to some embodiments. A first semiconductor region 202a may be an n-type semiconductor region for forming the n-type TFTs M1 and M5, a second semiconductor region 202b may be n-type semiconductor region for forming the n-type TFTs M2 and M6, a third semiconductor region 204a may be p-type semiconductor region for forming the p-type TFT M3, and a fourth semiconductor region 204b may be p-type semiconductor region for forming the p-type TFT M4. It should be noted that each of the semiconductor regions can represent a single semiconductor layer (such as a single crystalline semiconductor layer) or a plurality of stacked semiconductor layers. In some examples, each semiconductor region 202a/202b/204a/204b includes a metal oxide. For example, n-type semiconductor regions 202a and 202b may include any of zinc oxide (ZnO), indium tin oxide (InSnO), indium gallium oxide (InGaO), or indium gallium zinc oxide (InGaZnO), and p-type semiconductor regions 204a and 204b may include any of tin oxide (SnO), nickel oxide (NiO), or copper oxide (CuO). Other semiconductor materials suitable for TFTs may also be used.

According to some embodiments, the semiconductor regions 202a/202b/204a/204b are patterned and arranged in strips with their longest sides running parallel to one another along a first direction (top to bottom of page, in the plan view example of Figure 2B). Furthermore, the n-type semiconductor regions 202a/202b may be larger (e.g., longer) than the p-type semiconductor regions 204a/204b, and may be arranged such that the p-type semiconductor regions 204a/204b are adjacent along a second direction (left to right of page, in the plan view example of Figure 2B) orthogonal to the first direction and are between the n-type semiconductor regions 202a/202b along the second direction. Although the dimensions can vary from one example to the next, in some examples, each of the semiconductor regions 202a/202b/204a/204b has a width along the second direction between about 40 nm and about 60 nm (note that they can all have the same width, but it need not be the same); and each of n-type semiconductor regions 202a/202b has a length along the first direction between about 80 nm and about 240 nm, and each of p-type semiconductor regions 204a/204b has a length along the first direction between about 40 nm and about 120 nm.

According to some embodiments, a plurality of conductive lines 206a - 206e may run parallel to one another along the first second direction and beneath semiconductor regions 202a/202b/204a/204b. Conductive lines 206a - 206e may represent conductive traces in an interconnect layer beneath the semiconductor regions. Conductive lines 206a - 206e can include any suitable conductive material, such as copper, tungsten, cobalt, ruthenium, or molybdenum, to name a few examples.

According to some embodiments, conductive lines 206a - 206e contact source or drain regions of a given TFT M1 - M6. Each TFT includes a gate region between two source or drain regions. Thus, according to some embodiments, conductive line 206a contacts a first source or drain region of M5, conductive line 206b contacts a first source or drain region of M1, conductive line 206c contacts a first source or drain region of M3 and a first source or drain region of M4, conductive line 206d contacts a first source or drain region of M2, and conductive line 206e contacts a first source or drain region of M6. According to some embodiments, all other TFT contacts including those to the other source or drain regions and to the gates, are made by topside interconnects.

According to some embodiments, a first set of topside interconnects 208a and 208b are provided to contact the gates of access transistors M5 and M6. Topside interconnects 208a and 208b may represent a word line for the given SRAM cell. In some examples, topside interconnect 208a contacts a gate region of M5 and topside interconnect 208b contacts a gate region of M6. Topside interconnects 208a and 208b may include any suitable conductive material, such as any metal or polysilicon.

Interconnects between the various TFTs M1 - M6 may be provided using additional topside interconnects, such as a second set of topside interconnects 210a and 210b. According to some embodiments, each of topside interconnects 210a and 210b connects across all four semiconductor regions 202a/202b/204a/204b. For example, a first topside interconnect 210a contacts a shared second source or drain region of both M1 and M5, a second source or drain region of M3, a gate region of M4, and a gate region of M2, while a second topside interconnect 210b contacts a shared second source or drain region of both M2 and M6, a second source or drain region of M4, a gate region of M3, and a gate region of M1. Topside interconnects 210a and 210b may include various vertical and horizontal segments that extend along the first and second directions, respectively. Accordingly, each horizontal segment of topside interconnects 210a and 210b may contact either a gate or source/drain region of a TFT. According to some embodiments, the various horizontal segments of topside interconnects 210a and 210b run parallel and adjacent to one another and the various vertical segments of topside interconnects 210a and 210b run parallel and adjacent to one another, as illustrated in Figure 2B. Topside interconnects 210a and 210b may include any suitable conductive material, such as any metal or polysilicon.

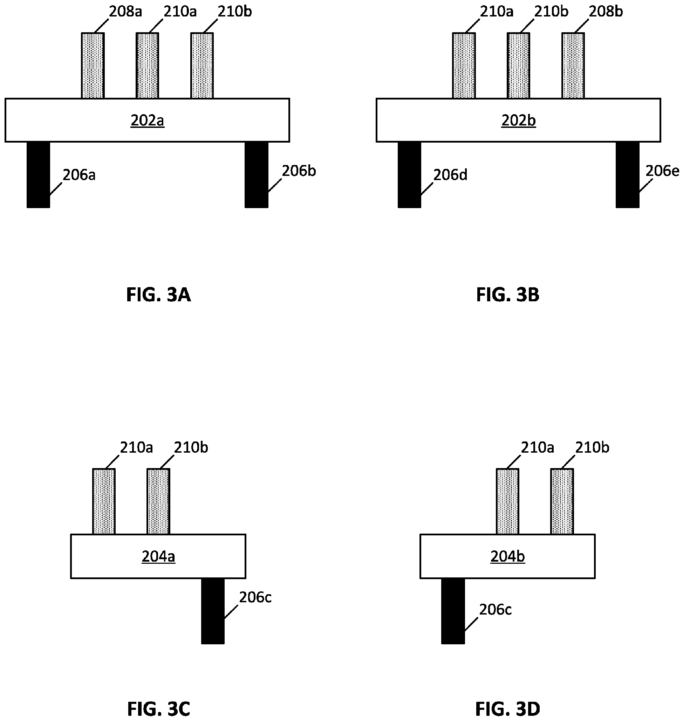

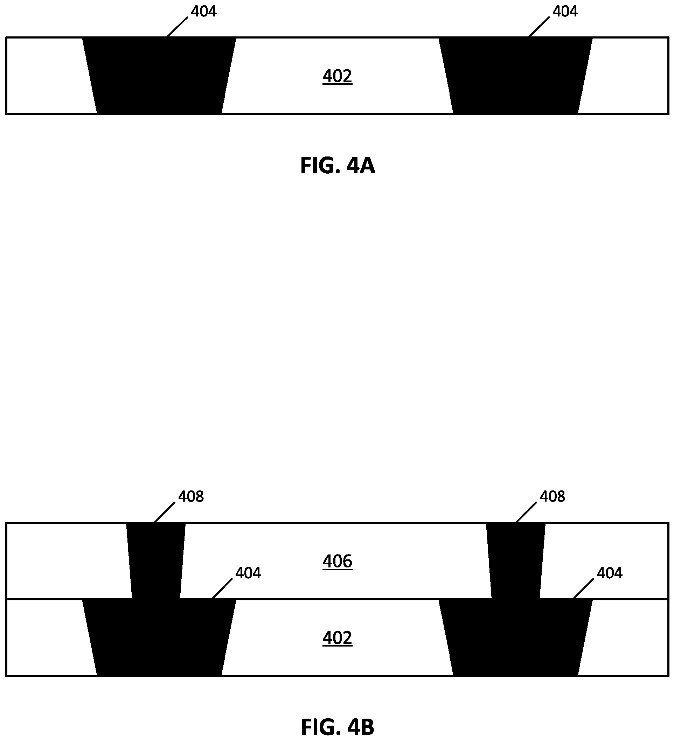

Figures 3A - 3D illustrate cross-sectional views of each of semiconductor regions 202a/202b/204a/204b along with their associated contacts, according to some embodiments. As seen in both Figures 3A and 3B, each n-type semiconductor region 202a and 202b is long enough to allow for two TFTs to be formed on it. According to some embodiments, each n-type semiconductor region 202a and 202b includes two TFTs with two contacts on the bottom surface of semiconductor region 202a and 202b and three contacts on or over the top surface of semiconductor region 202a and 202b. According to some embodiments, each p-type semiconductor region 204a and 204b includes one TFT with one contact on the bottom surface of semiconductor region 204a and 204b and two contacts on or over the top surface of semiconductor region 204a and 204b, as illustrated in Figures 3C - 3D. Further details regarding the fabrication of the TFTs are provided herein with reference to Figures 4A - 4E.

### Fabrication Methodology

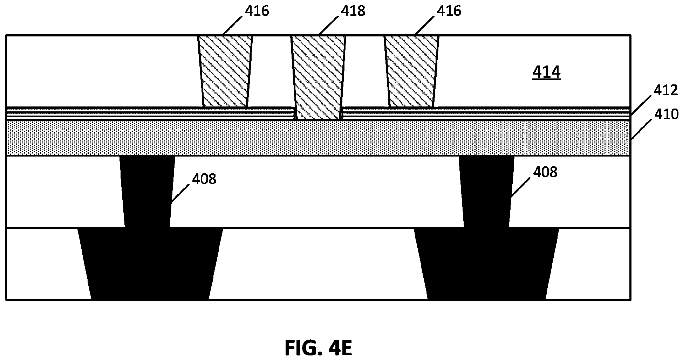

Figures 4A - 4E are cross-sectional views that collectively illustrate an example process for forming a portion of an interconnect region of an integrated circuit. According to an embodiment, the fabrication process for forming a portion of an SRAM cell using TFTs in the interconnect region is provided. Each figure shows an example structure that results from the process flow up to that point in time, so the depicted structure evolves as the process flow continues, culminating in the structure shown in Figure 4E, which provides a detailed view of a pair of n-channel TFTs sharing the same semiconductor region. The TFTs may be one TFT structure of a plurality of TFT structures across an array of memory structures (e.g., a single tier of SRAM memory structures). Each structure in the array may include any number of TFTs using the processes detailed here. Furthermore, as noted above, multiple tiers of memory arrays may be formed in the interconnect region. The TFT memory structures of each tier may be formed using the same general processes discussed here.

The TFTs illustrated in these figures may be part of an overall integrated circuit (e.g., such as a processor or memory chip, or a system-on-chip) that includes, for example, digital logic cells and/or memory cells and analog mixed signal circuitry. Example materials and process parameters are given, but other materials or parameters will be appreciated in light of this disclosure. It should be noted that the illustrated structures may be flipped such that any top surfaces become bottom surfaces and likewise any bottom surfaces become top surfaces.

Figure 4A is a cross-sectional view taken through a first interconnect layer of a plurality of stacked interconnect layers. Accordingly, the illustrated first interconnect layer may be at any position within interconnect region 103. According to some embodiments, the first interconnect layer includes a dielectric layer 402, which may be substantially similar to dielectric layer 112 as described in Figure 1.

According to some embodiments, one or more conductive traces 404 may be formed through dielectric layer 112. Conductive traces 404 may be formed, for example, by first forming one or more recesses through dielectric layer 402 followed by filling the recess with a conductive material, such as copper or tungsten, that is deposited using any one of electroplating, electroless plating, CVD, or PECVD, to name a few examples. After deposition of the conductive material within the recess, a polishing process may be performed using, for example, chemical mechanical polishing (CMP) to planarize the given layer down to a top surface of dielectric layer 402. In some embodiments, a thin barrier layer is conformally deposited (e.g., via ALD or CVD) first along the inner surfaces of the recess prior to the deposition of the copper or other conductive fill material. The thin barrier layer may include, for example, tantalum or titanium, or a nitride of these, or some other electromigration inhibitor. Conductive traces 404 may extend into and out of the page for any length to connect between various other elements.

Figure 4B is a cross-sectional view of the structure depicted in Figure 4A after formation of a second interconnect layer over the first interconnect layer, according to some embodiments. The second interconnect layer may include another dielectric layer 406, which may be substantially similar to dielectric layer 402, and one or more vias 408 on the underlying conductive traces 404. One or more vias 408 may be formed in a similar fashion to conductive traces 404 and may include similar conductive materials.

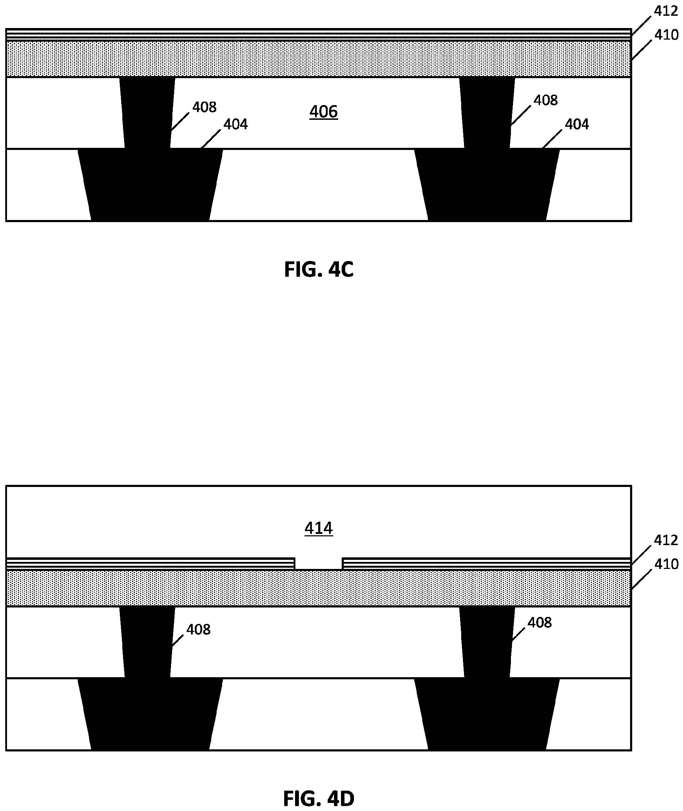

Figure 4C is a cross-sectional view of the structure depicted in Figure 4B after formation of a semiconductor region 410 and a gate dielectric 412 over semiconductor region 410, according to some embodiments. Semiconductor region 410 may represent a single semiconductor layer or a plurality of semiconductor layers. Semiconductor region 410 may include any suitable semiconductor material, such as silicon or any III-V or II-VI materials exhibiting semiconducting qualities. According to some embodiments, semiconductor region 410 includes any of indium doped zinc oxide (IZO), zinc tin oxide (ZTO), amorphous silicon (a-Si), amorphous germanium (a-Ge), low-temperature polycrystalline silicon (LTPS), transition metal dichalcogenide (TMD), yttrium-doped zinc oxide (YZO), polysilicon, poly germanium doped with boron, poly germanium doped with aluminum, poly germanium doped with phosphorous, poly germanium doped with arsenic, indium oxide, tin oxide, zinc oxide, gallium oxide, indium gallium zinc oxide (IGZO), copper oxide, nickel oxide, cobalt oxide, indium tin oxide, tungsten disulphide, molybdenum disulphide, molybdenum selenide, black phosphorus, indium antimonide, graphene, graphyne, borophene, germanene, silicene, Si₂BN (silicon-boron-nitrogen), stanene, phosphorene, molybdenite, poly-III-V like indium arsenide (InAs), indium gallium arsenide (InGaAs), indium phosphide (InP), amorphous indium gallium zinc oxide (InGaZnO, sometimes referred to as a-IGZO), crystal-like InGaZnO (sometimes referred to as c-IGZO), gallium zinc oxynitride (GaZnON), zinc oxynitride (ZnON), molybdenum and sulfur, a group-VI transition metal dichalcogenide, or a c-axis aligned crystal (CAAC) layer. Semiconductor region 410 may have a total thickness, for example, between about 5 nm and about 16 nm with any number of deposited material layers.

According to some embodiments, vias 408 directly contact a lower surface of semiconductor region 410. In some examples, the second interconnect layer is omitted such that semiconductor region 410 is formed directly on conductive traces 404.

According to some embodiments, gate dielectric 412 is formed directly on a top surface of semiconductor region 410. Gate dielectric 412 may be deposited, for example, to a thickness between about 2 nm and about 10. In some embodiments, gate dielectric 412 has a thickness up to about 50 nm. Gate dielectric 412 may include any suitable dielectric material (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, and lead scandium tantalum oxide. In some cases, gate dielectric 412 may include multiple layers, such as a first layer of high-k material (e.g., hafnium oxide) and a second layer of lower-k oxide between the first layer and semiconductor region 410. The lower-k oxide may be, for instance, silicon oxide or an oxide of semiconductor region 410.

Figure 4D is a cross-sectional view of the structure depicted in Figure 4C after patterning of gate dielectric 412 and the formation of an additional dielectric layer 414 over gate dielectric 412, according to some embodiments. Gate dielectric 412 may be patterned using any suitable lithography technique to provide an opening through gate dielectric 412 to expose the top surface of semiconductor region 410. The opening may be located anywhere between vias 408, such as equidistant between vias 408 (although such equidistance is not required, and other examples may have a degree of asymmetry where the opening is closer to one via 408 than it is to the other via 408). The additional dielectric layer 414 may be substantially similar to the previous interconnect dielectric layers 402 and 406.

Figure 4E is a cross-sectional view of the structure depicted in Figure 4C after formation of topside contacts to provide gate and source/drain contacts for the TFTs, according to some embodiments. According to some embodiments, one or more gate contacts 416 are formed through a thickness of dielectric layer 414 and landing upon a top surface of gate dielectric 412. Accordingly, gate dielectric 412 separates gate contacts 416 from semiconductor region 410. According to some embodiments, one or more source/drain contacts 418 extends through a thickness of dielectric layer 414 and through the opening in gate dielectric 412 to land upon a top surface of semiconductor region 410. Note that contact 118 may or may not touch gate dielectric layer 412 as it passes through the opening. Each of gate contacts 416 and source/drain contact 418 may include any suitable conductive material, such as polysilicon.

According to some embodiments, the illustrated semiconductor region 410 provides a shared semiconductor channel for two TFTs that share a source/drain terminal at source/drain contact 418. Each TFT then includes its own gate contact 416 and its own other source/drain terminal 418. It should be noted that the illustrated semiconductor region 410 may represent either n-type semiconductor region 402a or n-type semiconductor region 402b. Similar fabrication procedures can be used to form the p-type TFTs that use semiconductor regions 204a and 204b. Since all TFTs of a given SRAM cell are substantially coplanar in the same interconnect layer, the formation of each transistor element may be made simultaneously for each of the TFTs of the SRAM cell.

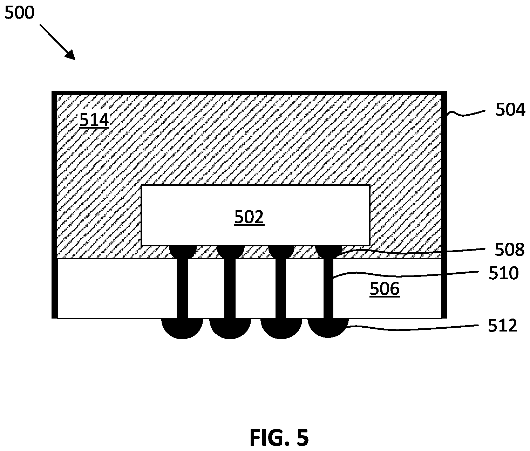

Figure 5 illustrates an example embodiment of a chip package 500, in accordance with an embodiment of the present disclosure. As can be seen, chip package 500 includes one or more dies 502. One or more dies 502 may include at least one integrated circuit having a structure as described in any of the aforementioned embodiments. One or more dies 502 may include any other circuitry used to interface with other devices formed on the dies, or other devices connected to chip package 500, in some example configurations.

As can be further seen, chip package 500 includes a housing 504 that is bonded to a package substrate 506. The housing 504 may be any standard or proprietary housing, and may provide, for example, electromagnetic shielding and environmental protection for the components of chip package 500. The one or more dies 502 may be conductively coupled to a package substrate 506 using connections 508, which may be implemented with any number of standard or proprietary connection mechanisms, such as solder bumps, ball grid array (BGA), pins, or wire bonds, to name a few examples. Package substrate 506 may be any standard or proprietary package substrate, but in some cases includes a dielectric material having conductive pathways (e.g., including conductive vias and lines) extending through the dielectric material between the faces of package substrate 506, or between different locations on each face. In some embodiments, package substrate 506 may have a thickness less than 1 millimeter (e.g., between 0.1 millimeters and 0.5 millimeters), although any number of package geometries can be used. Additional conductive contacts 512 may be disposed at an opposite face of package substrate 506 for conductively contacting, for instance, a printed circuit board (PCB). One or more vias 510 extend through a thickness of package substrate 506 to provide conductive pathways between one or more of connections 508 to one or more of contacts 512. Vias 510 are illustrated as single straight columns through package substrate 506 for ease of illustration, although other configurations can be used (e.g., damascene, dual damascene, through-silicon via, or an interconnect structure that meanders through the thickness of substrate 506 to contact one or more intermediate locations therein). In still other embodiments, vias 510 are fabricated by multiple smaller stacked vias, or are staggered at different locations across package substrate 506. In the illustrated embodiment, contacts 512 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 512, to inhibit shorting.

In some embodiments, a mold material 514 may be disposed around the one or more dies 502 included within housing 504 (e.g., between dies 502 and package substrate 506 as an underfill material, as well as between dies 502 and housing 504 as an overfill material). Although the dimensions and qualities of the mold material 514 can vary from one embodiment to the next, in some embodiments, a thickness of mold material 514 is less than 1 millimeter. Example materials that may be used for mold material 514 include epoxy mold materials, as suitable. In some cases, the mold material 514 is thermally conductive, in addition to being electrically insulating.

### Example System

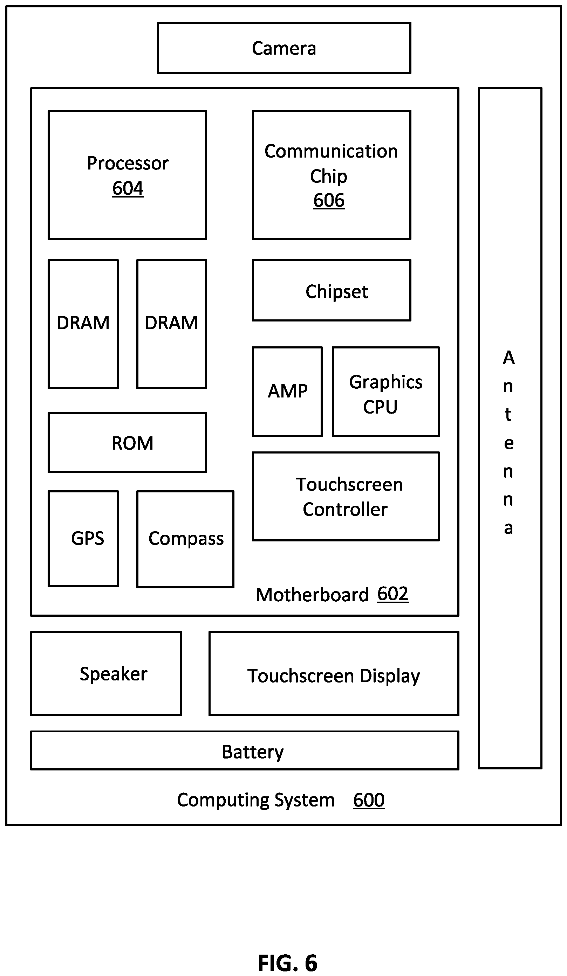

FIG. 6 is an example computing system implemented with one or more of the integrated circuit structures as disclosed herein, in accordance with some embodiments of the present disclosure. As can be seen, the computing system 600 houses a motherboard 602. The motherboard 602 may include a number of components, including, but not limited to, a processor 604 and at least one communication chip 606, each of which can be physically and electrically coupled to the motherboard 602, or otherwise integrated therein. As will be appreciated, the motherboard 602 may be, for example, any printed circuit board (PCB), whether a main board, a daughterboard mounted on a main board, or the only board of system 600, etc.

Depending on its applications, computing system 600 may include one or more other components that may or may not be physically and electrically coupled to the motherboard 602. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 600 may include one or more integrated circuit structures or devices configured in accordance with an example embodiment (e.g., a module including an integrated circuit having interconnect structures that include one or more backend SRAM memory cells made up of thin film transistors). In some embodiments, the inclusion of the backend memory cells may reduce the number of other memory chips included within computing system 600. In some embodiments, multiple functions can be integrated into one or more chips (e.g., for instance, note that the communication chip 606 can be part of or otherwise integrated into the processor 604).

The communication chip 606 enables wireless communications for the transfer of data to and from the computing system 600. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 606 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 600 may include a plurality of communication chips 606. For instance, a first communication chip 606 may be dedicated to shorter range wireless communications such as Wi-Fi and Bluetooth and a second communication chip 606 may be dedicated to longer range wireless communications such as GPS, EDGE, GPRS, CDMA, WiMAX, LTE, Ev-DO, and others.

The processor 604 of the computing system 600 includes an integrated circuit die packaged within the processor 604. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 606 also may include an integrated circuit die packaged within the communication chip 606. In accordance with some such example embodiments, the integrated circuit die of the communication chip includes one or more semiconductor devices as variously described herein. As will be appreciated in light of this disclosure, note that multistandard wireless capability may be integrated directly into the processor 604 (e.g., where functionality of any chips 606 is integrated into processor 604, rather than having separate communication chips). Further note that processor 604 may be a chip set having such wireless capability. In short, any number of processor 604 and/or communication chips 606 can be used. Likewise, any one chip or chip set can have multiple functions integrated therein.

In various implementations, the computing system 600 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 600 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a plurality of semiconductor devices, an interconnect region above the plurality of semiconductor devices and having a plurality of interconnect layers, and a plurality of thin film transistors (TFTs) arranged at least partially in an interconnect layer of the plurality of interconnect layers. The plurality of TFTs include a static random-access memory (SRAM) cell having four n-type TFTs and two p-type TFTs.

Example 2 includes the integrated circuit of Example 1, wherein two of the four n-type TFTs share a first semiconductor layer and the other two of the four n-type TFTs share a second semiconductor layer.

Example 3 includes the integrated circuit of Example 2, wherein the first semiconductor layer and the second semiconductor layer are arranged such that their longest sides are parallel to one another.

Example 4 includes the integrated circuit of Example 2 or 3, wherein one of the two p-type TFTs includes a third semiconductor layer and the other one of the two p-type TFTs includes a fourth semiconductor layer.

Example 5 includes the integrated circuit of Example 4, wherein each of the first semiconductor layer, second semiconductor layer, third semiconductor layer, and fourth semiconductor layer are arranged such that their longest sides are parallel to one another.

Example 6 includes the integrated circuit of Example 5, wherein the two p-type TFTs are arranged between the four n-type TFTs.

Example 7 includes the integrated circuit of any one of Examples 4-6, wherein the two of the four n-type TFTs comprise a first metal line beneath the first semiconductor layer and a second metal line beneath the first semiconductor layer, and the other two of the four n-type TFTs comprise a third metal line beneath the second semiconductor layer and a fourth metal line beneath the second semiconductor layer.

Example 8 includes the integrated circuit of Example 7, wherein the one of the two p-type TFTs comprises a fifth metal line beneath the third semiconductor layer, and the other one of the two p-type TFTs comprises the fifth metal line beneath the fourth semiconductor layer.

Example 9 includes the integrated circuit of Example 8, wherein each of the first metal line, second metal line, third metal line, fourth metal line, and fifth metal line extend parallel to one another beneath the SRAM cell.

Example 10 includes the integrated circuit of any one of Examples 2-9, wherein the two of the four n-type TFTs comprise at least three conductive lines on a top surface of the first semiconductor layer, and the other two of the four n-type TFTs comprise at least three conductive lines on a top surface of the second semiconductor layer.

Example 11 includes the integrated circuit of Example 10, wherein each of the conductive lines comprises polysilicon.

Example 12 includes the integrated circuit of any one of Examples 1-11, further comprising a local interconnect coupled to a shared source or drain region between two of the four n-type TFTs, a source or drain region of one of the p-type TFTs, a gate of the other one of the p-type TFTs, and a gate of one of the other two of the four n-type TFTs.

Example 13 includes the integrated circuit of Example 12, wherein the local interconnect is a first local interconnect and the integrated circuit further comprises a second local interconnect coupled to a gate of the one of the two of the four n-type TFTs, a gate of the one of the p-type TFTs, a source or drain region of the other one of the p-type TFTs, and a shared source or drain region between the other two of the four n-type TFTs.

Example 14 includes the integrated circuit of Example 13, wherein the first local interconnect and the second local interconnect each comprise polysilicon.

Example 15 includes the integrated circuit of any one of Examples 1-14, wherein the SRAM cell is one SRAM cell of a plurality of SRAM cells arranged across the interconnect layer.

Example 16 is a printed circuit board that includes the integrated circuit of any one of Examples 1-15.

Example 17 is an electronic device that includes a chip package having one or more dies. At least one of the one or more dies includes an interconnect region above a plurality of semiconductor devices and having a plurality of interconnect layers, and a plurality of thin film transistors (TFTs) arranged at least partially in an interconnect layer of the plurality of interconnect layers. The plurality of TFTs include a static random-access memory (SRAM) cell having four n-type TFTs and two p-type TFTs.

Example 18 includes the electronic device of Example 17, wherein two of the four n-type TFTs share a first semiconductor layer and the other two of the four n-type TFTs share a second semiconductor layer.

Example 19 includes the electronic device of Example 18, wherein the first semiconductor layer and the second semiconductor layer are arranged such that their longest sides are parallel to one another.

Example 20 includes the electronic device of Example 18 or 19, wherein one of the two p-type TFTs includes a third semiconductor layer and the other one of the two p-type TFTs includes a fourth semiconductor layer.

Example 21 includes the electronic device of Example 20, wherein each of the first semiconductor layer, second semiconductor layer, third semiconductor layer, and fourth semiconductor layer are arranged such that their longest sides are parallel to one another.

Example 22 includes the electronic device of Example 21, wherein the two p-type TFTs are arranged between the four n-type TFTs.

Example 23 includes the electronic device of any one of Examples 20-22, wherein the two of the four n-type TFTs comprise a first metal line beneath the first semiconductor layer and a second metal line beneath the first semiconductor layer, and the other two of the four n-type TFTs comprise a third metal line beneath the second semiconductor layer and a fourth metal line beneath the second semiconductor layer.

Example 24 includes the electronic device of Example 23, wherein the one of the two p-type TFTs comprises a fifth metal line beneath the third semiconductor layer, and the other one of the two p-type TFTs comprises the fifth metal line beneath the fourth semiconductor layer.

Example 25 includes the electronic device of Example 24, wherein each of the first metal line, second metal line, third metal line, fourth metal line, and fifth metal line extend parallel to one another beneath the SRAM cell.

Example 26 includes the electronic device of any one of Examples 18-25, wherein the two of the four n-type TFTs comprise at least three conductive lines on a top surface of the first semiconductor layer, and the other two of the four n-type TFTs comprise at least three conductive lines on a top surface of the second semiconductor layer.

Example 27 includes the electronic device of Example 26, wherein each of the conductive lines comprises polysilicon.

Example 28 includes the electronic device of any one of Examples 17-27, wherein the at least one of the one or more dies further comprises a local interconnect coupled to a shared source or drain region between two of the four n-type TFTs, a source or drain region of one of the p-type TFTs, a gate of the other one of the p-type TFTs, and a gate of one of the other two of the four n-type TFTs.

Example 29 includes the electronic device of Example 28, wherein the local interconnect is a first local interconnect and the at least one of the one or more dies further comprises a second local interconnect coupled to a gate of the one of the two of the four n-type TFTs, a gate of the one of the p-type TFTs, a source or drain region of the other one of the p-type TFTs, and a shared source or drain region between the other two of the four n-type TFTs.

Example 30 includes the electronic device of Example 29, wherein the first local interconnect and the second local interconnect each comprise polysilicon.

Example 31 includes the electronic device of any one of Examples 17-30, wherein the SRAM cell is one SRAM cell of a plurality of SRAM cells arranged across the interconnect layer.

Example 32 includes the electronic device of any one of Examples 17-31, further comprising a printed circuit board, wherein the chip package is coupled to the printed circuit board.

Example 33 is an integrated circuit that includes an interconnect region above a plurality of semiconductor devices and having a plurality of interconnect layers, a first n-type TFT and a second n-type TFT sharing a first semiconductor layer, a first p-type TFT having a second semiconductor layer, a second p-type TFT having a third semiconductor layer, and a third n-type TFT and a fourth n-type TFT sharing a fourth semiconductor layer. Each of the TFTs are on a same interconnect layer of the plurality of interconnect layers. Each of the first semiconductor layer, second semiconductor layer, third semiconductor layer, and fourth semiconductor layer are arranged such that their longest sides are parallel to one another.

Example 34 includes the integrated circuit of Example 33, wherein the second and third semiconductor layers are arranged between the first and fourth semiconductor layers.

Example 35 includes the integrated circuit of Example 33 or 34, further comprising a first metal line beneath the first semiconductor layer, a second metal line beneath the first semiconductor layer, a third metal line beneath the second semiconductor layer and the third semiconductor layer, a fourth metal line beneath the fourth semiconductor layer, and a fifth metal line beneath the fourth semiconductor layer.

Example 36 includes the integrated circuit of Example 35, wherein each of the first metal line, second metal line, third metal line, fourth metal line, and fifth metal line extend parallel to one another.

Example 37 includes the integrated circuit of any one of Examples 33-36, wherein the first n-type TFT and the second n-type TFT comprise at least three conductive lines on a top surface of the first semiconductor layer, and the third n-type TFT and the fourth n-type TFT comprise at least three conductive lines on a top surface of the fourth semiconductor layer.

Example 38 includes the integrated circuit of Example 37, wherein each of the conductive lines comprises polysilicon.

Example 39 includes the integrated circuit of any one of Examples 33-38, further comprising a local interconnect coupled to a shared source or drain region between the first n-type TFT and the second n-type TFT, a source or drain region of the first p-type TFT, a gate of the second p-type TFT, and a gate of the third n-type TFT or the fourth n-type TFT.

Example 40 includes the integrated circuit of Example 39, wherein the local interconnect is a first local interconnect and the integrated circuit further comprises a second local interconnect coupled to a gate of the first n-type TFT or the second n-type TFT, a gate of the first p-type TFT, a source or drain region of the second p-type TFT, and a shared source or drain region between the third n-type TFT and the fourth n-type TFT.

Example 41 includes the integrated circuit of Example 40, wherein the first local interconnect and the second local interconnect each comprise polysilicon.

Example 42 is a printed circuit board that includes the integrated circuit of any one of Examples 33-41.

Example 43 is an integrated circuit that includes a plurality of semiconductor devices, an interconnect region above the plurality of semiconductor devices and having a plurality of interconnect layers, and a plurality of thin film transistors (TFTs) arranged at least partially in an interconnect layer of the plurality of interconnect layers. The plurality of TFTs comprises a static random-access memory (SRAM) cell. At least two of the TFTs share a first semiconductor layer and at least one other of the TFTs includes a second semiconductor layer. The first semiconductor layer and the second semiconductor layer are arranged such that their longest sides are parallel to one another.

Example 44 includes the integrated circuit of Example 43, wherein at least one additional other of the TFTs includes a third semiconductor layer, and wherein the first, second, and third semiconductor layers are arranged such that their longest sides are parallel to one another.

Example 45 includes the integrated circuit of Example 43, wherein at least two others of the TFTs share a third semiconductor layer and at least one additional other of the TFTs includes a fourth semiconductor layer, and wherein the first, second, third, and fourth semiconductor layers are arranged such that their longest sides are parallel to one another.

Example 46 includes the integrated circuit of Example 45, wherein the second and fourth semiconductor layers are arranged between the first and third semiconductor layers.

Example 47 includes the integrated circuit of Example 45 or 46, wherein the first, second, third, and fourth semiconductor layers are parallel with each other and in a staggered fashion.

Example 48 includes the integrated circuit of any one of Examples 43-46, wherein the first and second semiconductor layers are parallel with each other but in a staggered fashion.

Example 49 includes the integrated circuit of any one of Examples 43-48, wherein the SRAM cell is one SRAM cell of a plurality of SRAM cells arranged across the interconnect layer.

Example 50 is a printed circuit board that includes the integrated circuit of any one of Examples 43-49.

The foregoing description of the embodiments of the disclosure has been presented for the purposes of illustration and description. It is not intended to be exhaustive or to limit the disclosure to the precise forms disclosed. Many modifications and variations will be apparent in light of this disclosure. It is intended that the scope of the disclosure be limited not by this detailed description, but rather by the claims appended hereto.

## Claims

1. An integrated circuit, comprising:
a plurality of semiconductor devices;
an interconnect region above the plurality of semiconductor devices, the interconnect region comprising a plurality of interconnect layers; and
a plurality of thin film transistors (TFTs) arranged at least partially in an interconnect layer of the plurality of interconnect layers, wherein the plurality of TFTs comprises a static random-access memory (SRAM) cell having four n-type TFTs and two p-type TFTs.

2. The integrated circuit of claim 1, wherein two of the four n-type TFTs share a first semiconductor layer and the other two of the four n-type TFTs share a second semiconductor layer.

3. The integrated circuit of claim 2, wherein the first semiconductor layer and the second semiconductor layer are arranged such that their longest sides are parallel to one another.

4. The integrated circuit of claim 2 or 3, wherein one of the two p-type TFTs includes a third semiconductor layer and the other one of the two p-type TFTs includes a fourth semiconductor layer.

5. The integrated circuit of claim 4, wherein each of the first semiconductor layer, second semiconductor layer, third semiconductor layer, and fourth semiconductor layer are arranged such that their longest sides are parallel to one another.

6. The integrated circuit of claim 5, wherein the two p-type TFTs are arranged between the four n-type TFTs.

7. The integrated circuit of any one of claims 4 through 6, wherein the two of the four n-type TFTs comprise a first metal line beneath the first semiconductor layer and a second metal line beneath the first semiconductor layer, and the other two of the four n-type TFTs comprise a third metal line beneath the second semiconductor layer and a fourth metal line beneath the second semiconductor layer.

8. The integrated circuit of claim 7, wherein the one of the two p-type TFTs comprises a fifth metal line beneath the third semiconductor layer, and the other one of the two p-type TFTs comprises the fifth metal line beneath the fourth semiconductor layer.

9. The integrated circuit of claim 8, wherein each of the first metal line, second metal line, third metal line, fourth metal line, and fifth metal line extend parallel to one another beneath the SRAM cell.

10. The integrated circuit of any one of claims 2 through 9, wherein the two of the four n-type TFTs comprise at least three conductive lines on a top surface of the first semiconductor layer, and the other two of the four n-type TFTs comprise at least three conductive lines on a top surface of the second semiconductor layer.

11. The integrated circuit of claim 10, wherein each of the conductive lines comprises polysilicon.

12. The integrated circuit of any one of claims 1 through 11, further comprising a local interconnect coupled to a shared source or drain region between two of the four n-type TFTs, a source or drain region of one of the p-type TFTs, a gate of the other one of the p-type TFTs, and a gate of one of the other two of the four n-type TFTs.

13. The integrated circuit of claim 12, wherein the local interconnect is a first local interconnect and the integrated circuit further comprises a second local interconnect coupled to a gate of the one of the two of the four n-type TFTs, a gate of the one of the p-type TFTs, a source or drain region of the other one of the p-type TFTs, and a shared source or drain region between the other two of the four n-type TFTs.

14. The integrated circuit of claim 13, wherein the first local interconnect and the second local interconnect each comprise polysilicon.

15. The integrated circuit of any one of claims 1 through 14, wherein the SRAM cell is one SRAM cell of a plurality of SRAM cells arranged across the interconnect layer.
